# EUROPEAN PATENT SPECIFICATION

(11) **EP 0 412 986 B1**
(45) Date of publication and mention of the grant of the patent: **28.06.1995**
(21) Application number: 89905146.0
(22) Date of filing: 21.04.1989
(51) Int. Cl.: H01L 39/24, H01L 39/22, H01L 23/15, H01L 23/14

(54) **EPITAXIAL DEPOSITION**
EPITAKTISCHE ABSCHEIDUNG
DEPOT EPITAXIAL

(30) Priority: 22.04.1988 GB 8809548
(43) Date of publication of application: 20.02.1991
(73) Proprietor: BRITISH TECHNOLOGY GROUP LIMITED, London SE1 6BU (GB)
(72) Inventor: EVETTS, Jan, Edgar, Cambridge CB3 9JH (GB); SOMEKH, Robert, Ernest, Cambridge CB1 2HL (GB)
(74) Representative: Cullis, Roger
(86) International application number: GB8900430
(87) International publication number: WO8910634

(56) References cited:
- EP-A- 292 959
- EP-A- 0 301 525
- EP-A- 0 304 078
- CRC Handbook of Chemistry and Physics, 65th Ed., 1984-1985, page E-83
- Physical Review Letters, Vol. 58, No. 25, 22 June 1987, pp. 2684-2686
- Commission of the European Communities, Eur. Workshop on High Tc Superconductors and Potential Applications, 1-3 July 1987, Genova (IT), M.G. Blamire et al.: "Preparation and properties of high Tc superconducting films and device structures", pages 129-130
- Patent Abstracts of Japan, volume 11, no. 390 (E-567)(2837), 19 December 1987 & JP-A-62 154 676
- Japanese Journal of Applied Physics, part 2: Letters, volume 27, no. 3, March 1988, H. Koinuma et al.: "Preparation of high-TcBi-Sr-Ca-Su-O superconducting thin films by AC sputtering", pp.L376-L377
- A.I.P. Conf. Proc., no. 165, 1988, Topical Conf. on Thin Film Processing & Characterization of High Tc Supercond., 6 November 1987, Anaheim, CA, American Institute of Physics, (US), D. Burbidge et al.: "Sputter deposition of Y-Ba-Cu-O compound system", pp. 87-94
- IBM Technical Disclosure Bulletin, volume 27, no. 3, August 1984, (New York, US), W. Anacker: "Feedback-controlled fabrication of tunnel barriers by RF oxidation", pp. 1529-1531
- Patent Abstracts of Japan, volume 11, no. 271 (E-536)(2718), 3 September 1987 & JP-A-62 72 187
- Patent Abstracts of Japan, volume 11, no. 187 (E-516)(2634), 16 June 1987 & JP-A-62 15 869

## Description

This invention relates to the formation of high quality single crystal or near single crystal epitaxial barrier layers and, in particular, to the formation of such layers either as a preliminary to, or at an intermediate stage of, the fabrication of multilayer thin film structures for application in solid state devices or circuits. Such layers formed epitaxially on a single crystal substrate may act either as a chemical barrier to prevent the migration of impurities or as an electrical barrier to control or eliminate the passage of electric current.

Thin film devices and microelectronic circuits are frequently formed by growing perfect single crystal or near single crystal layers on substrate wafers that are themselves single crystal. The films are said to be epitaxial when their crystal orientation is determined during growth by matching to the lattice periodicity of the substrate. Furthermore when a multilayer thin film is formed epitaxy may sometimes be maintained by matching each layer to some lattice periodicity in the preceding layer. High quality epitaxial layers are required either for their electrical or magnetic properties or alternatively as insulating or dielectric layers or as barrier layers to prevent chemical interdiffusion and degradation of layers by separating them physically.

Sometimes the application envisaged does not require single crystal epitaxy as far as the actual performance of a particular layer itself is concerned. However, epitaxy may still be necessary so as to transfer epitaxial growth to a layer to be subsequently deposited which does require epitaxy for it to function correctly in the application envisaged.

European Patent Application No 301525 discloses the manufacture of a solid state device by depositing an epitaxial layer of magnesia on a single crystal silicon substrate and depositing an epitaxial layer of a YBaCuO superconductor on the magnesia layer.

Physical Review Letters 58, No. 25, 22 June 1987, pp 2684-2686 discloses an expitaxial film of YBaCuO on a monocrystalline strontium titanate substrate.

We have found that the deleterious effects of diffusion of materials from a substrate in a device formed in a superconducting layer may be obviated by the presence of a substantially mono-layer of a film containing a metal and oxygen between the superconducting layer and the substrate.

According to one aspect of the invention there is provided a method of manufacture of solid state devices comprising the formation of an epitaxial layer of magnesia by sputtering of material from a magnesium-containing target on to an alumina-containing substrate and the subsequent formation of an expitaxial layer of a compound including yttrium, barium, copper and oxygen on said layer of magnesia.

There is also provided a solid state device comprising a first epitaxial layer of a material selected from the class including superconductors and semiconductors formed on a second epitaxial layer including a metallic oxide on a crystalline substrate.

One embodiment of the present invention provides a method to form an epitaxial barrier layer of magnesia (MgO) on a substrate wafer of sapphire (Al₂O₃).

Another embodiment of the invention provides a method of introducing very thin layers of epitaxial magnesia between two layers of high temperature ceramic superconductor having structures related to the perovskite structure.

The invention also contemplates a method of introducing single monolayers of magnesium atoms within a thin film single crystal of high temperature ceramic superconductor with a structure related to the perovskite structure.

In a specific embodiment a single crystal sapphire substrate was coated with an epitaxial barrier layer of magnesia (MgO) by vapour deposition onto the heated substrate. The preferred temperature for the substrate during deposition is 750°C-900°C, although it may be as low as 540°C. The crystallographic orientation of the MgO barrier layer depends on the crystallographic orientation of the plane of the Al₂O₃ substrate wafer. In particular MgO can be formed with a (100) plane matching epitaxially to r-plane (101̅2) sapphire, or with a (110) plane matching epitaxially to m-plane (011̅0) sapphire, or with a (111) plane matching epitaxially to a-plane (112̅0) or c-plane (0001) sapphire

Although this invention has general application in thin film device technology one particular application of importance is in superconducting device technology based on high temperature ceramic superconductors having structures related to the perovskite structure.

In the preferred embodiment of the invention an MgO layer is formed by DC magnetron sputter deposition from a magnesium metal target in a sputtering gas composed of 40% oxygen in argon at a pressure of 1-2 pascals. The preferred deposition rate is 0.05 nanometres per second.

In a second embodiment of the invention an MgO layer is formed by RF sputter deposition from a magnesium metal target or from an MgO oxide target.

In a third embodiment of the invention an MgO layer is deposited by ion beam sputtering from a magnesium metal target or from an MgO oxide target.

In a fourth embodiment of the invention an MgO layer is deposited by laser evaporation from an MgO target.

In a fifth embodiment of the invention an MgO layer is deposited by thermal evaporation or molecular beam evaporation (MBE) of magnesium metal in an oxidising atmosphere.

In a sixth embodiment of the invention an MgO layer is deposited by chemical vapour deposition (CVD) or metal-organic chemical vapour deposition (MOCVD) from suitable chemical precursors.

The MgO epitaxial layer may form a substrate for a further layer of deposited material that derives its epitaxy from the MgO layer. In particular this layer may be an epitaxial layer of high temperature ceramic superconductor with a structure related to the perovskite structure. The barrier layer prevents interdiffusion of aluminium into the superconductor and consequent degradation of superconducting properties.

The invention allows an epitaxial barrier layer or layers to be provided which separate epitaxial layers of high temperature ceramic superconducting material, with structures related to the perovskite structure.

In a preferred embodiment of the invention the barrier layer consists of a single monolayer of magnesium incorporated epitaxially into the perovskite lattice on oxygen vacancies in the structure or on other suitable crystallographic sites in the lattice. The necessary overall properties may be achieved by inserting an appropriate number of monolayer barriers closely spaced in the epitaxial structure. The monolayer barriers shall be on planes parallel to the (001) plane of the perovskite structure.

In a second embodiment of the invention the barrier layer may be an epitaxial layer of MgO deposited on a base electrode of high temperature superconducting ceramic with a structure related to the perovskite structure. When an appropriate thickness of MgO has been deposited an epitaxial counter electrode of ceramic superconductor can be deposited.

The invention will now be described by way of example with reference to the accompanying drawings in which:-
- Figure 1: shows a cross-section of a multilayer film on a sapphire substrate,
- Figures 2-6: show the variation of deposited film compositions as various parameters are varied; and
- Figures 7a and 7b: are x-ray diffraction patterns showing epitaxial relationships of MgO films on sapphire substrates

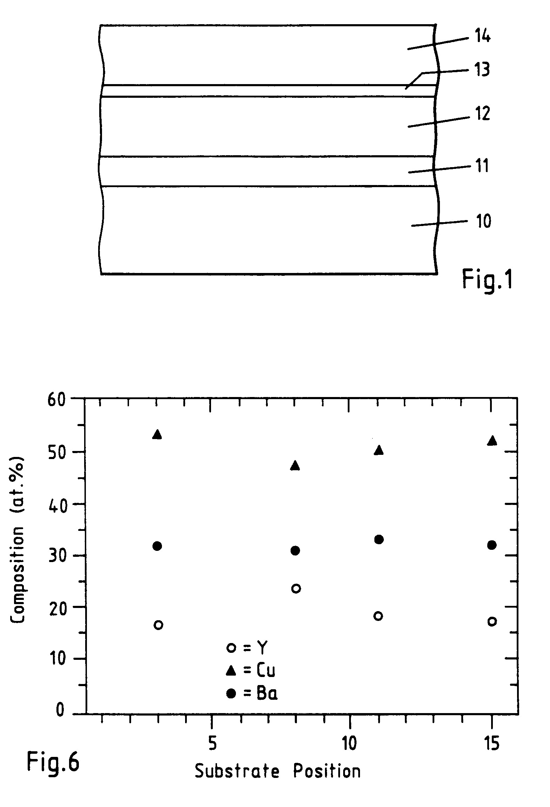

Referring now to Figure 1 of the drawings, a sapphire wafer (10) is 0.6mm thick with r-plane (101̅2) orientation. A buffer layer (11) of magnesia 100 nanometres thick is deposited epitaxially. The single crystal magnesia layer forms a substrate for an epitaxial layer (12) of Y₁Ba₂Cu₃O₇ of thickness 200 nanometres orientated with the (001) plane parallel to the substrate. Two single monolayers of magnesium (13) are deposited separated by 0.8nm. Finally a counterelectrode 14 of (001) orientation Y₁Ba₂Cu₃O₇ is deposited to a thickness of 200 nanometres.

Although the illustration relates to a superconducting device, the invention is not limited to this and other applications involving epitaxial barrier layers of MgO on sapphire are envisaged.

For example, in the embodiment of Figure 1, there are two monolayers of magnesium separated by 0.8nm. However, it is possible to tailor the precise structure to the requirements of device fabrication. By using a separate source for magnesium and injecting a flux of magnesium as the superconductor is being deposited, sufficient magnesium to form a monolayer of MgO is deposited. It is not even necessary to stop the deposition of superconductor while this takes place. The superconductor deposition is allowed to continue, to deposit one unit cell, or so, and then more magnesium is injected. The objective is to depress the superconductive properties over a barrier region.

With superconductive devices the objective is to have a base electrode of superconductor and then a non-superconducting, preferably insulating, barrier followed by another superconducting layer all being epitaxially strucutred with relation to one another. It is not possible to structure the thickness of a layer of magnesia optimally, but, by using a sequence of magnesium monolayers separated by a controlled thickness of superconductor, desired properties may be achieved.

Other materials may be used for the barrier layer. In particular, the use of zirconia or strontium titanate is possible.

We have formed films in an ultra-high vacuum dc magnetron sputter deposition system using the method described by R.E.Somekh and Z.H. Barber "UHV sputter deposition with a research scale dc magnetron" J.Physics E **21**, pp. 1029-1033. This is usable for both pure metal composite targets and sintered ceramic targets.

A metal target, measuring 35mm by 55mm, consisted of a surround of copper with yttrium and barium at the two ends of the racetrack in proportions roughly 1:2 divided by a 3-5mm strip of copper. It was operated at a target-substrate distance of 70mm and a sputtering pressure of 2-3Pa. Oxygen was injected into the system close to the substrates using a showerhead arrangement to reduce oxidation of the target.

In a second embodiment, a ceramic target was used. To minimise the composition variation between target and film caused by resputtering due to negative oxygen ions, an operating pressure in the region 15 to 40 Pa was chosen, with a target distance of 20-30mm. The composition of the ceramic target was adjusted to give the correct film composition at this high sputtering pressure. Several iterations were required, with tiles of composition (1:2:3); (1:3.3:4.2); (1:2.5:4.8); and finally (1:3.9:6.1) being fabricated. The targets were made by carefully calcining a well mixed powder of BaCO₃, Y₂O₃ and CuO at 890°C for 72 hours then hydrostatically compacting the reground powder at a pressure of 16MPa to form three tiles. After compaction these were fired at 900°C for 36-56 hours. To prevent the tiles cracking due to differential heating during sputtering, the operating power was reduced to 16W.

The substrates were placed on a platinum strip heater, the substrate of which was measured with an optical pyrometer. As the substrates were well coated, their temperature could also be measured directly with only small interference of the transmitted radiation from the heater beneath. Measurements indicated that the substrates were cooler than the heater by about 160°-200°C with the heater at 900°C. Following deposition, the YBaCuO films were heat treated in situ, cooling from 600°C to 350°C over a period of an hour in 100 mbar of oxygen.

The sputtering parameters of pressure, temperature and oxygen concentration were measured using energy-dispersive x-ray analysis with a flat piece of sintered YBa₂Cu₃O₇ made up from high purity powders as internal standard.

MgO was deposited on to sapphire substrates at a temperature of 850°-900°C from a pure magnesium target in an argon/15% oxygen mixture. The target ran in oxide mode and there was some interaction between the oxidation level of the metal and the radiation from the heater and power loading of the magnetron. It was found that the target oxidation was accelerated if the power loading was too large, and hence a power level of only 25W was used to give consistent deposition.

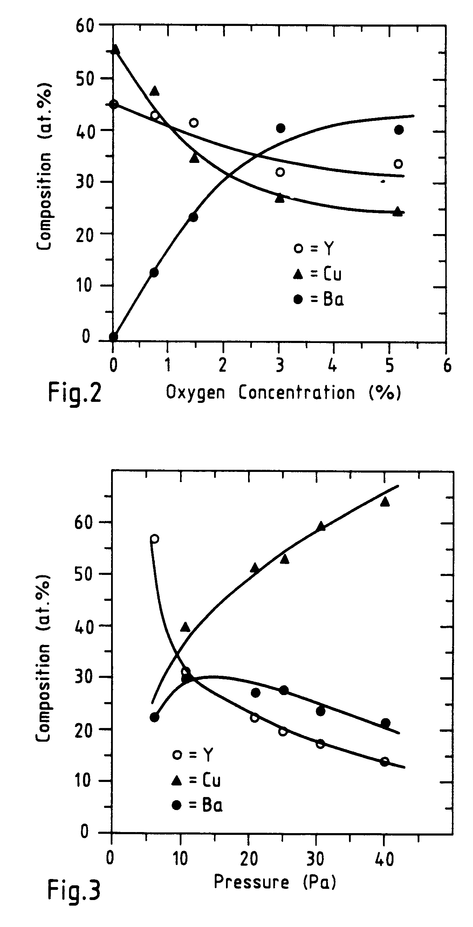

The effect of varying the oxygen concentration in the sputtering gas with a metal target is shown in Figure 2. This indicates the necessity of oxygen for the 'sticking' of barium at elevated temperatures, where the native barium has a tendency to reevaporate unless it is incorporated into the structure.

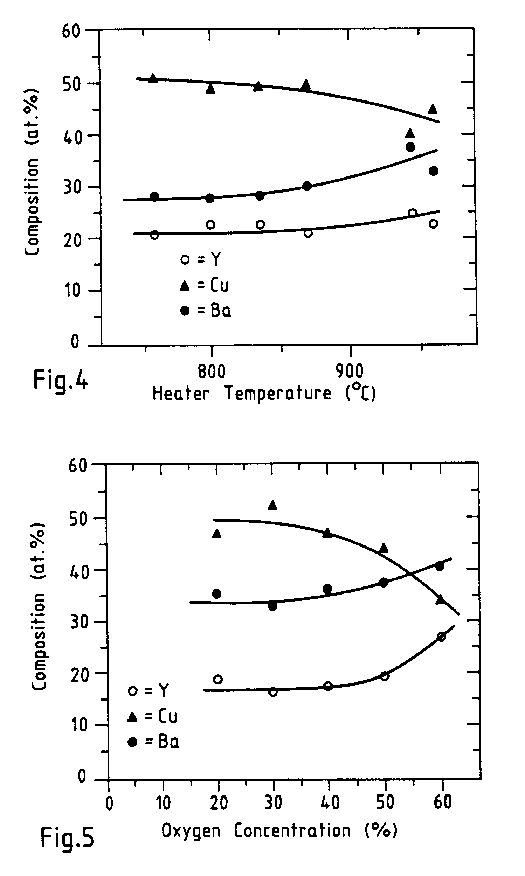

The effects of changing deposition parameters on film composition are shown in Figures 3 to 5. These illustrate the degree of preferential resputtering occurring in this system and indicate the required degree of control for a specified tolerance in film composition. At low pressures resputtering due to energetic oxygen anions is enhanced, with copper and barium being preferentially removed. At high temperatures, the copper shows a tendency to reevaporate.

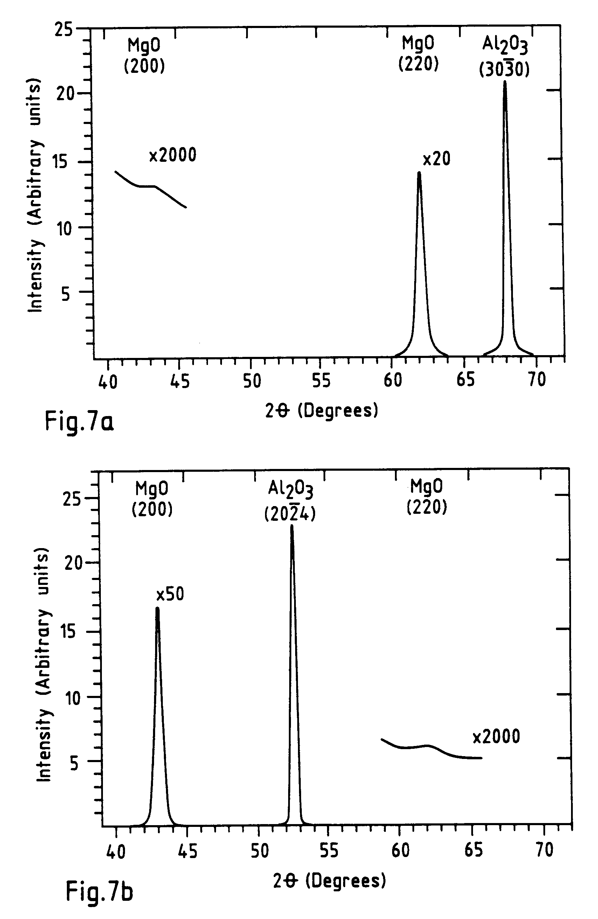

When operating the system at such small working distances, it was found that there was some compositional variation along the heater, as shown in Figure 6. This effect could be reduced by altering the compositions of the end tiles.

The major effect of this work has been aimed at making the YBaCuO directly on to an epitaxial MgO film on Al₂O₃. In an original embodiment the MgO was deposited on to sapphire substrates which were transferred to another system in which the YBaCuO was deposited, but a later embodiment has combined the two deposition steps so that the YBaCuO could be deposited directly without breaking the vacuum.

We have deposited MgO epitaxially on to four different orientations of sapphire. (111) MgO grew on both a-plane (112̅0) and c-plane (0001), whilst (110) MgO grew on m-plane (101̅0) and (100) MgO grew on r-plane sapphire. Figure 7 shows x-ray diffraction patterns from a vertical diffractometer. These illustrate there is a mosaic spread of ±0.2% for both epitaxial lines. In addition, the (111) MgO peak was present in both traces, with an intensity of between 0.5% and 1% of the epitaxial lines. Although this represents less than perfect epitaxy, improvements can be achieved with further optimisation of the deposition conditions.

Although most of our x-ray analysis has been performed with a vertical diffractometer which necessitated the tilting of the sample with respect to the incident beam to maximise the peak intensity, we have recently decoupled ϑ and 2ϑ using a two-circle diffractometer. This has shown that the (110) MgO pole is inclined by about 0.8° from the m-plane substrate and the (100) MgO pole is inclined by about 5.5° (±0.5°) from the r-plane, on the zone linking (101̅2) and (0001). This indicates a systematic correlation between the MgO and sapphire lattices, although there is a discrepancy of between 3° and 5° with this alignment.

As an illustration of the effect of the barrier layer on T_{c}; a film on an epitaxial MgO layer on sapphire had a zero resistance temperature of 50 K whilst a film deposited on sapphire directly had a broader transition down to 10 K. A film deposited on to YSZ showed a zero resistance temperature of 75 K. When the thickness of MgO was varied from 80 to 320nm, it was found that the YBaCuO films deposited on to the thicker MgO could be heated in flowing oxygen at 850°C for more than an hour without any degradation in their resistivities.

We have found that ideally, to achieve 0.1% compositional accuracy when growing thin films of YBa₂Cu₃O₇ on to hot substrates, the temperature should be controlled to ±2.5°C, the sputtering pressure to ±0.5% and the oxygen concentration to within 1%.

For the fabrication of electronic devices such as planar tunnel junctions from epitaxial YBaCuO films, the (110) face is to be preferred, as all atomic sites are exposed at one time, rather than needing many growth ledges to accommodate atoms as they arrive. Furthermore, the tendency to form an extra CuO plane stacking fault and the Y₂Ba₄Cu₈Oₓ phase is obviated.

By nucleating the correct epitaxy relationship at high temperature, the deposition temperature could be reduced, whilst still preserving the preferred growth orientation.

In a further embodiment of the method, we have replaced oxygen with nitrous oxide in the sputtering process because its lower activation energy increases the density of activated species.

Shapes other than a flat substrate may be used as a basis for the deposition. For example, ribbons are one possibility.

## Claims

1. A method of manufacture of solid state devices characterised in that it comprises depositing a metal-containing material on a substrate to form an at least partially epitaxial monolayer of a compound including the metal and oxygen and depositing a further at least partially epitaxial layer of a different material on the surface of said monolayer.

2. A method of manufacture of solid state devices as claimed in claim 1 characterised in that said metal-containing material includes at least one metal from the group comprising magnesium, strontium, titanium and zirconium.

3. A method of manufacture of solid state devices as claimed in claim 2 characterised in that said metal-containing material includes magnesium.

4. A method of manufacture of solid state devices as claimed in claim 1 characterised in that the substrate includes alumina.

5. A method of manufacture of solid state devices as claimed in claim 1 characterised in that the substrate is a semiconductor.

6. A method of manufacture of solid state devices as claimed in claim 1 characterised in that the substrate is a superconductor.

7. A method of manufacture of solid state devices as claimed in claim 6 characterised in that the substrate is a high temperature superconductor with a substantially perovskite structure.

8. A method of manufacture of solid state devices as claimed in claim 1 characterised in that said further layer is a ceramic superconductor

9. A method of manufacture of solid state devices as claimed in claim 1 characterised in that said further layer comprises a compound of yttrium, barium, copper and oxygen.

10. A method of manufacture of solid state devices comprising the formation of an epitaxial layer of magnesia by sputtering of material from a magnesium-containing target on to an alumina-containing substrate and the subsequent formation of an expitaxial layer of a compound including yttrium, barium, copper and oxygen on said layer of magnesia.

11. A method of manufacture of solid state devices as claimed in claim 10 characterised in that said substrate is heated to a temperature of between 750°C and 900°C whilst the material is sputtered from said magnesium containing target.

12. A method of manufacture of solid state devices as claimed in claim 11 characterised in that an oxidising ambient atmosphere is maintained whilst the material is sputtered from said magnesium containing target.

13. A method of manufacture of solid state devices as claimed in claim 12 characterised in that the oxidising ambient atmosphere includes oxygen.

14. A method of manufacture of solid state devices as claimed in claim 12 characterised in that the oxidising ambient atmosphere includes nitrous oxide.

15. A method of manufacture of solid state devices as claimed in either claim 13 or claim 14 characterised in that the oxidising ambient atmosphere includes argon.

16. A solid state device characterised in that it comprises a first epitaxial layer (12) of a material selected from the class including superconductors and semiconductors formed on a second epitaxial monolayer (11) including a metallic oxide formed on a crystalline substrate (10).

17. A solid state device as claimed in claim 16 characterised in that said metallic oxide is magnesia.

18. A solid state device as claimed in claim 17 characterised in that said crystalline substrate includes alumina.

19. A solid state device as claimed in claim 18 characterised in that said first epitaxial layer is a superconductor including yttrium, barium, copper and oxygen.

20. A solid state device as claimed in claim 19 characteresed in that it includes a layer of magnesia having its (100) plane contiguous with the (101̅2) of an alumina substrate.

21. A solid state device as claimed in claim 19 characterised in that it includes a layer of magnesia having its (110) plane contiguous with the (011̅0) of an alumina substrate.

22. A solid state device as claimed in claim 19 characterised in that it includes a layer of magnesia having its (111) plane contiguous with the (112̅0) of an alumina substrate.

23. A solid state device as claimed in claim 19 characterised in that it includes a layer of magnesia having its (111) plane contiguous with the (0001) of an alumina substrate.

24. A method of forming a barrier layer in a solid state device characterised in that it comprises depositing an epitaxial layer of a superconductor material on a substrate, depositing a monolayer of a second material comprising a compound of a metal and oxygen on said epitaxial layer and depositing a further epitaxial layer of said superconductor material on said monolayer.

25. A method of forming a barrier layer in a solid state device as claimed in claim 24 characterised in that said monolayer is deposited simultaneously with said further epitaxial layer.

26. A method of forming a barrier layer in a solid state device as claimed in either claim 24 or claim 25 characterised in that a plurality of monolayers of said second material and corresponding further epitaxial layers of said superconductor material are successively deposited on said substrate.

## Patentansprüche

1. Verfahren zur Herstellung von Festkörperbauteilen,
dadurch gekennzeichnet, daß es das Abscheiden eines Metall enthaltenden Materials auf einem Substrat, um eine zumindest teilweise epitaktische Monolage einer Verbindung zu bilden, die das Metall und Sauerstoff enthält, und das Abscheiden einer weiteren zumindest teilweise epitaktischen Schicht eines anderen Materials auf der Oberfläche der Monolage umfaßt.

2. Verfahren zur Herstellung von Festkörperbauteilen nach Anspruch 1,
dadurch gekennzeichnet, daß das Metall enthaltende Material zumindest ein Metall aus der Gruppe umfassend Magnesium, Strontium, Titan und Zirkon enthält.

3. Verfahren zur Herstellung von Festkörperbauteilen nach Anspruch 2,
dadurch gekennzeichnet, daß das Metall enthaltende Material Magnesium enthält.

4. Verfahren zur Herstellung von Festkörperbauteilen nach Anspruch 1,
dadurch gekennzeichnet, daß das Substrat Aluminiumoxid enthält.

5. Verfahren zur Herstellung von Festkörperbauteilen nach Anspruch 1,
dadurch gekennzeichnet, daß das Substrat ein Halbleiter ist.

6. Verfahren zur Herstellung von Festkörperbauteilen nach Anspruch 1,
dadurch gekennzeichnet, daß das Substrat ein Supraleiter ist.

7. Verfahren zur Herstellung von Festkörperbauteilen nach Anspruch 6,
dadurch gekennzeichnet, daß das Substrat ein Hochtemperatur-Supraleiter ist, der im wesentlischen eine Perowskit-Struktur aufweist.

8. Verfahren zur Herstellung von Festkörperbauteilen nach Anspruch 1,
dadurch gekennzeichnet, daß die weitere Schicht ein keramischer Supraleiter ist.

9. Verfahren zur Herstellung von Festkörperbauteilen nach Anspruch 1,
dadurch gekennzeichnet, daß die weitere Schicht eine Verbindung aus Yttrium, Barium, Kupfer und Sauerstoff enthält.

10. Verfahren zur Herstellung von Festkörperbauteilen unter Bildung einer epitaktischen Schicht aus Magnesiumoxid durch Sputtern von Material von einem Magnesium enthaltenden Ziel auf ein Aluminiumoxid enthaltendes Substrat und der anschließenden Bildung einer epitaktischen Schicht einer Verbindung, die Yttrium, Barium, Kupfer und Sauerstoff enthält, auf der Schicht aus Magnesiumoxid.

11. Verfahren zur Herstellung von Festkörperbauteilen nach Anspruch 10,
dadurch gekennzeichnet, daß das Substrat auf eine Temperatur von zwischen 750°C und 900°C geheizt wird, während das Material aus dem Magnesium enthaltenden Ziel gesputtert wird.

12. Verfahren zur Herstellung von Festkörperbauteilen nach Anspruch 11,
dadurch gekennzeichnet, daß eine oxidierende Umgebungsatmosphäre aufrecht erhalten wird, während das Material aus dem Magnesium enthaltenden Ziel gesputtert wird.

13. Verfahren zur Herstellung von Festkörperbauteilen nach Anspruch 12,
dadurch gekennzeichnet, daß die oxidierende Umgebungsatmosphäre Sauerstoff enthält.

14. Verfahren zur Herstellung von Festkörperbauteilen nach Anspruch 12,
dadurch gekennzeichnet, daß die oxidierende Umgebungsatmosphäre Distickstoffoxid enthält.

15. Verfahren zur Herstellung von Festkörperbauteilen nach entweder Anspruch 13 oder Anspruch 14,
dadurch gekennzeichnet, daß die oxidierende Umgebungsatmosphäre Argon enthält.

16. Festkörperbauteil,
dadurch gekennzeichnet, daß es eine erste epitaktische Schicht (12) aus einem Material umfaßt, das aus der Supraleiter und Halbleiter enthaltenden Klasse ausgewählt ist, die auf einer zweiten epitaktischen Monolage (11), die ein Metalloxid enthält, auf einem kristallinen Substrat (10) gebildet ist.

17. Festkörperbauteil nach Anspruch 16,
dadurch gekennzeichnet, daß Metalloxid Magnesiumoxid ist.

18. Festkörperbauteil nach Anspruch 17,
dadurch gekennzeichnet, daß das kristalline Substrat Aluminiumoxid enthält.

19. Festkörperbauteil nach Anspruch 18,
dadurch gekennzeichnet, daß die erste epitaktische Schicht ein Supraleiter ist, der Yttrium, Barium, Kupfer und Sauerstoff enthält.

20. Festkörperbauteil nach Anspruch 19,
dadurch gekennzeichnet, daß es eine Schicht aus Magnesiumoxid enthält, die ihre (100) Ebene aneinandergrenzend mit der (101̅2) eines Aluminiumoxidsubstrats hat.

21. Festkörperbauteil nach Anspruch 19,
dadurch gekennzeichnet, daß es eine Schicht aus Magnesiumoxid enthält, die ihre (110) Ebene aneinandergrenzend mit der (011̅0) eines Aluminiumoxidsubstrats hat.

22. Festkörperbauteil nach Anspruch 19,
dadurch gekennzeichnet, daß es eine Schicht aus Magnesiumoxid enthält, die ihre (111) Ebene aneinandergrenzend mit der (112̅0) eines Aluminiumoxidsubstrats hat.

23. Festkörperbauteil nach Anspruch 19,
dadurch gekennzeichnet, daß es eine Schicht aus Magnesiumoxid enthält, die ihre (111) Ebene aneinandergrenzend mit der (0001) eines Aluminiumoxidsubstrats hat.

24. Verfahren zur Bildung einer Sperrschicht in einem Festkörperbauteil,
dadurch gekennzeichnet, daß es das Abscheiden einer epitaktischen Schicht eines supraleitenden Materials auf einem Substrat, das Abscheiden einer Monolage eines zweiten Materials enthaltend eine Verbindung vom einem Metall und Sauerstoff auf der epitaktischen Schicht und das Abscheiden einer weiteren epitaktischen Schicht auf dem supraleitenden Material auf der Monolage umfaßt.

25. Verfahren zur Bildung einer Sperrschicht in einem Festkörperbauteil nach Anspruch 24,
dadurch gekennzeichnet, daß die Monolage gleichzeitig mit der weiteren epitaktischen Schicht abgeschieden wird.

26. Verfahren zur Bildung einer Sperrschicht in einem Festkörperbauteil nach entweder Anspruch 24 oder Anspruch 25,
dadurch gekennzeichnet, daß eine Vielzahl von Monolagen des zweiten Materials und entsprechender weiterer epitaktischer Lagen des supraleitenden Materials nacheinander auf dem Substrat abgeschieden werden.

## Revendications

1. Procédé de fabrication de dispositifs à l'état solide, caractérisé en ce qu'il comprend le dépôt d'une matière contenant un métal sur un substrat pour former une couche monocristalline au moins partiellement épitaxiale d'un composé comprenant le métal et de l'oxygène et le dépôt d'une autre couche au moins partiellement épitaxiale d'une matière différente sur la surface de ladite couche monocristalline.

2. Procédé de fabrication de dispositifs à l'état solide selon la revendication 1, caractérisé en ce que ladite matière contenant un métal comporte au moins un métal du groupe comprenant le magnésium, le strontium, le titane et le zirconium.

3. Procédé de fabrication de dispositifs à l'état solide selon la revendication 2, caractérisé en ce que ladite matière contenant un métal comporte du magnésium.

4. Procédé de fabrication de dispositifs à l'état solide selon la revendication 1, caractérisé en ce que le substrat comporte de l'alumine.

5. Procédé de fabrication de dispositifs à l'état solide selon la revendication 1, caractérisé en ce que le substrat est un semiconducteur.

6. Procédé de fabrication de dispositifs à l'état solide selon la revendication 1, caractérisé en ce que le substrat est un supraconducteur.

7. Procédé de fabrication de dispositifs à l'état solide selon la revendication 6, caractérisé en ce que le substrat est un supraconducteur haute température sensiblement à structure de pérovskite.

8. Procédé de fabrication de dispositifs à l'état solide selon la revendication 1, caractérisé en ce que ladite autre couche est un supraconducteur céramique.

9. Procédé de fabrication de dispositifs à l'état solide selon la revendication 1, caractérisé en ce que ladite autre couche comprend un composé d'yttrium, de baryum, de cuivre et d'oxygène.

10. Procédé de fabrication de dispositifs à l'état solide, comprenant la formation d'une couche épitaxiale de magnésie par pulvérisation de matière, arrachée à une cible contenant du magnésium, sur un substrat contenant de l'alumine, puis la formation d'une couche épitaxiale d'un composé comprenant de l'yttrium, du baryum, du cuivre et de l'oxygène sur ladite couche de magnésie.

11. Procédé de fabrication de dispositifs à l'état solide selon la revendication 10, caractérisé en ce que ledit substrat est chauffé à une température de 750°C à 900°C pendant que la matière de la cible contenant du magnésium est pulvérisée.

12. Procédé de fabrication de dispositifs à l'état solide selon la revendication 11, caractérisé en ce qu'une atmosphère ambiante oxydante est entretenue pendant que la matière de la cible contenant du magnésium est pulvérisée.

13. Procédé de fabrication de dispositifs à l'état solide selon la revendication 12, caractérisé en ce que l'atmosphère ambiante oxydante comprend de l'oxygène.

14. Procédé de fabrication de dispositifs à l'état solide selon la revendication 12, caractérisé en ce que l'atmosphère ambiante oxydante comprend de l'oxyde nitreux.

15. Procédé de fabrication de dispositifs à l'état solide selon la revendication 13 ou 14, caractérisé en ce que l'atmosphère ambiante oxydante comprend de l'argon.

16. Dispositif à l'état solide, caractérisé en ce qu'il comporte une première couche épitaxiale (12) en matière choisie dans la classe comprenant des supraconducteurs et des semiconducteurs, formée sur une seconde mouche épitaxiale monocristalline (11) qui comprend un oxyde métallique, formée sur un substrat cristallin (10).

17. Dispositif à l'état solide selon la revendication 16, caractérisé en ce que ledit oxyde métallique est la magnésie.

18. Dispositif à l'état solide selon la revendication 17, caractérisé en ce que ledit substrat cristallin contient de l'alumine.

19. Dispositif à l'état solide selon la revendication 18, caractérisé en ce que ladite première couche épitaxiale est un supraconducteur comprenant de l'yttrium, du baryum, du cuivre et de l'oxygène.

20. Dispositif à l'état solide selon la revendication 19, caractérisé en ce qu'il comporte une couche de magnésie dont le plan (100) est contigu au plan (1012) d'un substrat en alumine.

21. Dispositif à l'état solide selon la revendication 19, caractérisé en ce qu'il comporte une couche de magnésie dont le plan (100) est contigu au plan (0110) d'un substrat en alumine.

22. Dispositif à l'état solide selon la revendication 19, caractérisé en ce qu'il comporte une couche de magnésie dont le plan (111) est contigu au plan (1120) d'un substrat en alumine.

23. Dispositif à l'état solide selon la revendication 19, caractérisé en ce qu'il comporte une couche de magnésie dont le plan (111) est contigu au plan (0001) d'un substrat en alumine.

24. Procédé de formation d'une couche d'arrêt dans un dispositif à l'état solide, caractérisé en ce qu'il comprend le dépôt d'une couche épitaxiale en matière supra-conductrice sur un substrat, le dépôt d'une couche monocristalline d'une seconde matière comprenant un composé d'un métal et d'oxygène sur ladite couche épitaxiale et le dépôt d'une autre couche épitaxiale de ladite matière supraconductrice sur ladite couche monocristalline.

25. Procédé de formation d'une couche d'arrêt dans un dispositif à l'état solide selon la revendication 24, caractérisé en ce que ladite couche monocristalline est déposée en même temps que ladite autre couche épitaxiale.

26. Procédé de formation d'une couche d'arrêt dans un dispositif à l'état solide selon la revendication 24 ou la revendication 25, caractérisé en ce qu'une pluralité de couches monocristallines de ladite seconde matière et d'autres couches épitaxiales correspondantes de ladite matière supraconductrice sont successivement déposées sur ledit substrat.
